# EUROPÄISCHE PATENTSCHRIFT

(11) **EP 1 070 927 B1**
(45) Veröffentlichungstag und Bekanntmachung des Hinweises auf die Patenterteilung: **09.02.2005**
(21) Anmeldenummer: 00114710.7
(22) Anmeldetag: 08.07.2000
(51) Int. Cl.: F26B 15/12, F26B 13/10, F26B 21/00

(54) **Durchlauftrockner für Platten oder Bahnen**
Continuous dryer for plates or webs
Sécheur en continue de plaques ou de bandes

(30) Priorität: 22.07.1999 DE 19934487
(43) Veröffentlichungstag der Anmeldung: 24.01.2001
(73) Patentinhaber: Systronic Systemlösungen für die Elektronikindustrie GmbH, 74223 Flein (DE)
(72) Erfinder: Krauss, Rainer, 74382 Neckarwestheim (DE)
(74) Vertreter: Dreiss, Fuhlendorf, Steimle & Becker

(56) Entgegenhaltungen:
- EP-A- 0 513 632
- EP-A- 0 631 098
- WO-A-97/06895
- DE-A- 2 203 621
- DE-A- 2 754 438
- DE-A- 3 517 541
- DE-A- 19 623 303
- DE-B- 1 095 246
- DE-C- 973 047
- DE-C- 975 015
- DE-U- 9 000 821
- DE-U- 9 104 417
- GB-A- 1 583 199
- GB-A- 2 043 860
- GB-A- 2 088 426
- US-A- 3 579 853
- US-A- 4 270 283

## Beschreibung

Die Erfindung betrifft einen Durchlauftrockner für Platten oder Bahnen, insbesondere für beschichtete Innenlagen oder Leiterplatten, nach dem Oberbegriff des Anspruchs 1, eine Beschichtungsanlage für Platten oder Bahnen sowie ein Verfahren zum Trocknen von Platten oder Bahnen.

Zur Herstellung von beispielsweise Leiterbahnen auf Leiterplatten, oder bei mehrschichtigen Leiterplatten auf den sog. Innenlagen (In-Layers), werden die üblicherweise kupferkaschierten Epoxitharzglasfasergewebe mit einem Fotolack oder mit einer ähnlichen lichtempfindlichen und entwickelbaren Polymerschicht nass beschichtet und die Beschichtung in einem Durchlauftrockner getrocknet. Die gewünschte Leiterbahnenstruktur wird auf die getrocknete Beschichtung aufgeleuchet und die Beschichtung wird an den belichteten (oder je nach Fotolacktyp an den unbelichteten) Stellen heraus entwickelt. Bei einem nachfolgenden Ätzprozess wird das Kupfer an den freigelegten Stellen weggeätzt, die beschichteten Stellen hingegen sind gegen den Ätzangriff geschützt. Nach dem Ablösen der restlichen Beschichtung, dem sog. Stripping, liegt die Leiterplatte bzw. die Innenlage mit der gewünschten Leiterbahnenstruktur vor.

Auf ähnliche Art und Weise werden beispielsweise auch siebartige Strukturen aus sehr dünnen, ggf. endlosen Blechbahnen hergestellt. Dazu wird die Blechbahn mit einem entsprechenden Lack beschichtet, der nach der Beschichtung in einem Durchlauftrockner getrocknet wird. Aufgrund der Belichtung des Lacks wird in dem Ätzprozess die Blechbahn in der Regel an den freigelegten Stellen vollständig weggeätzt, wodurch eine siebartige Struktur gewonnen wird.

Auch folienartige und/oder flexible Bahnen werden zur industriellen Verwendung beschichtet und anschließend getrocknet. Zur Führung einer solchen Bahn durch einen Durchlauftrockner kann die Bahn beispielsweise an ihren Seitenrändern von Transportmitteln gehalten und so über die Breite der Transportbahn aufgespannt werden.

Die Anforderungen an einen die Erfindung betreffenden Durchlauftrockner für Platten oder Bahnen werden im Nachfolgenden beispielhaft anhand von der Beschichtung und Trocknung von Leiterplatten bzw. Innenlagen erläutert.

Die Beschichtung und Trocknung von Leiterplatten bzw. von Innenlagen erfolgt in einer Beschichtungsanlage. Eine solche Beschichtungsanlage umfasst üblicherweise eine Beschichtungsstation, in der die Innenlagen bzw. die Leiterplatten ein- oder beidseitig mit Fotolack o.ä. beschichtet werden. Im Anschluss an die Beschichtungsstation ist eine Trocknungsstation vorhanden, in der der Fotolack getrocknet wird und dabei abdampfendes Lösungsmittel, insbesondere Alkohole und/oder Wasser, von der Leiterplatte bzw. der Innenlage weg und zur Abluft transportiert wird.

Ein Durchlauftrockner für plattenförmiges Stückgut ist aus der EP 0 631 098 B1 bekannt. Nach diesem Stand der Technik wird ein Luftstrom im Wesentlichen parallel zu einer Transportbahn über das zu trocknende Stückgut so geführt, dass der Luftstrom in der Trocknungskammer im Wesentlichen laminar ist. Aufgrund der laminaren Strömung bildet sich entlang dem Stückgut eine laminare Grenzschicht, innerhalb der die Strömungslinien idealerweise parallel zueinander verlaufen. Eine solche laminare Grenzschicht zeichnet sich dadurch aus, dass lediglich eine Längsbewegung der einzelnen Strömungsteilchen vorhanden ist. Ein Vermischen des entlang des Stückguts strömenden Luftstromes findet dadurch nicht statt. Dies hat zum Nachteil, dass die Luft innerhalb der Grenzschicht relativ schnell mit den in der Trocknungskammer abdampfenden Lösungsmitteln gesättigt ist und keine weiteren Lösungsmittel aufnehmen kann, was eine Verlangsamung des Trocknungsvorgangs zur Folge hat.

Ein weiterer Nachteil dieses Stands der Technik ist, dass die Strömungsgeschwindigkeit des Luftstromes entlang des Stückguts relativ gering sein muss, um eine parallele und laminare Strömung über die gesamte Länge des Durchlauftrockners zu erreichen. Auch dies führt zu einer Erhöhung der Trocknungszeiten.

Ein wichtiges Kriterium für den Trocknungsvorgang ist die Temperatur innerhalb des Durchlauftrockners. Diese kann nicht beliebig hoch sein, da zum einen die Gefahr besteht, dass sich bei entzündbaren Lösungsmitteldämpfen diese entzünden. Zum anderen können sich bei zu starker Heizung Blasen, sog. Kochblasen, bilden, die die Gleichmäßigkeit und die Qualität der Beschichtung verringern, was zu einer Unbrauchbarkeit der Leiterplatte bzw. der Innenlage führen kann.

Außerdem ist darauf zu achten, dass je nach gewünschter Qualität der Leiterbahnenstrukturen in der Trocknungsstation Reinraumbedingungen vorliegen müssen. Dadurch wird vermieden, dass beispielsweise Schmutzpartikel in der Beschichtung als Streuzentren im Belichtungsschritt wirken oder gar einzelne Bereiche derart markieren, dass die vorgegebene Leiterbahnenstruktur nicht völlig auf den Lack abgebildet wird.

Aus der DE-B-10 95 246 ist eine Vorrichtung zum kontinuierlichen Behandeln von bahnartigem Gut, beispielsweise Gewebe- und Papierbahnen, bekannt geworden. Derartige Vorrichtungen sehen ein Paar Düsen schräg zur Warenbahn und schräg gegeneinander angeordnet vor, die über je einen Kanal mit einem gemeinsamen, einen Teilluftstromkreislauf schließenden Mittelkanal in Verbindung stehen. In dem Mittelkanal ist ein Gebläse für das Behandlungsmittel angeordnet. In den Kreislauf sind Heizkörper eingeschaltet. Bei diesem Stand der Technik wird das Trockenmittel von der Bahn durch den Absaugkanal abgesaugt und wieder in den Umlauf gebracht. Die einzelnen einander zugeordneten Düsenpaare bilden mit dem zugehörigen Gebläse folglich einen Kreislauf für den jeweiligen Teilluftstrom.

Es ist daher die Aufgabe der vorliegenden Erfindung, den vorstehend geschilderten Nachteilen des Standes der Technik abzuhelfen. Es soll ein Durchlauftrockner und ein zugehöriges Trocknungsverfahren für beschichtete Platten oder Bahnen geschaffen werden, wodurch eine schnelle und dennoch sehr gleichmäßige, qualitativ hochwertige Trocknung der Beschichtung gewährleistet wird. Der Durchlauftrockner soll dabei außerdem so konzipiert sein, dass er die Bereitstellung einer Beschichtungsanlage erlaubt.

Zur Lösung der Aufgabe wird ein Durchlauftrockner mit den Merkmalen des Patentanspruchs 1, eine Beschichtungsanlage mit den Merkmalen des Patentanspruchs 24 und ein Verfahren zum Trocknen von Platten oder Bahnen mit den Merkmalen des Anspruchs 27 vorgeschlagen. Besonders bevorzugte und vorteilhafte Ausführungsvarianten sind jeweils Gegenstand der abhängigen Patentansprüche.

Durch die Erfindung wird insbesondere ein Durchlauftrockner für Platten oder Bahnen, insbesondere für beschichtete Leiterplatten oder Innenlagen, vorgeschlagen, der eine Trocknungskammer und die Platte oder Bahn entlang einer Transportbahn in Transportrichtung durch die Transportkammer von einem Kammereingang zu einem Kammerausgang transportierende Transportmittel aufweist. In der Trocknungskammer ist dabei ein entgegen die Transportrichtung zwangsgeführter Luftstrom vorhanden, der von mehreren Gebläseeinheiten erzeugt und mit Heizelementen aufgeheizt wird. Die Gebläseeinheiten sind dabei ober- und/oder unterhalb entlang der Transportbahn parallel zur Transportbahn angeordnet. Außerdem weisen die Gebläseeinheiten jeweils einen zu der Transportrichtung quer, vorzugsweise unter einem Winkel von 90°, gelegenen Spalt auf, durch welchen Teilluftströme des Luftstromes unter einem Anblaswinkel von 90° bis 15°, vorzugsweise 60° bis 45°, bezüglich der Transportbahn entgegen der Transportrichtung auf die Platte oder Bahn bzw. auf die Transportbahn geblasen werden.

Die Erfindung weist dabei den Vorteil auf, dass aufgrund des Anblasens der Platte oder Bahn unter einem Anblaswinkel von 90° bis 15°, vorzugsweise 60° bis 45°, bezüglich der Transportbahn entgegen der Transportrichtung entlang der Platte oder Bahn die Bildung einer laminaren Grenzschicht weitgehend ausgeschlossen wird. Vielmehr bildet sich entlang der Platte oder Bahn eine turbulente Grenzschicht, deren Dicke geringer ist als die Dicke einer laminaren Grenzschicht. Bei einer solchen turbulenten Grenzschichtströmung treten zusätzlich zu den Längsbewegungen der einzelnen Strömungsteilchen, wie sie bei laminaren Grenzschichten vorhanden sind, noch ungeordnete Querbewegungen der Strömungsteilchen hinzu, wodurch sich ein verwirbeltes Strömungsbild ergibt. Ein solches Strömungsbild weist eine stete Vermischung des Luftstromes entlang der Platte oder Bahn auf. Aufgrund einer solchen Vermischung wird der Luftaustausch entlang der Platte oder Bahn gegenüber dem Stand der Technik erheblich verbessert und einer Sättigung der Strömung mit abgedampften Lösungsmitteln innerhalb einer Grenzschicht entgegengewirkt. Dadurch wird der Trocknungsvorgang deutlich beschleunigt.

Nach einer Ausgestaltung der Erfindung ist der Spalt weitgehend parallel zur Transportbahn und deckt in Längsausdehnung die Breite der Transportbahn voll ab, d.h. die Platte oder Bahn wird über die gesamte Breite mit heißer Luft angeblasen. Eine solche Art des Anblasens weist insbesondere den Vorteil auf, dass eine gute und gleichmäßige Temperaturverteilung der Leiterplatte gewährleistet ist, welche Voraussetzung für eine gleichmäßige, daran anschließende Ätzung ist. Grundsätzlich sollte die Temperaturdifferenz innerhalb der Platte oder Bahn nicht größer als ca. +/- 4°C sein, um eine Leiterplatte guter Qualität zu erhalten.

Eine andere Ausbildung der Erfindung sieht vor, dass die Trocknungskammer mehrere Heizzonen, insbesondere drei Prozess- und zwei Zuluftheizzonen aufweist. Dabei können die Heizzonen so abgestimmt sein, dass lediglich die ersten Heizzonen die Platte oder Bahn aufheizen und die weiteren Heizzonen die Platte oder Bahn auf der in den ersten Heizzonen aufgeheizten Temperatur halten. Eine solche Anordnung weist den Vorteil auf, dass im Anschluss an die Beschichtung der Platte oder Bahn die Platte oder Bahn relativ schnell und intensiv aufgeheizt wird, d.h. auf Betriebstemperatur gebracht wird. Insbesondere durch gleichmäßiges Anblasen der Platte oder Bahn mit heißer Luft wird ein gleichmäßiges und schnelles Aufheizen der Platte oder Bahn erreicht. In den weiteren Heizzonen findet nach dieser Ausgestaltung der Erfindung keine weitere zusätzliche Erhitzung der Platte oder Bahn statt. Dadurch kann mit relativ hohen Luftgeschwindigkeiten die Platte oder Bahn erfindungsgemäß angeblasen werden, wodurch eine sehr schnelle und intensive Trocknung der Beschichtung erzielt wird.

Weitere vorteilhafte Ausgestaltungen und Einzelheiten der Erfindung sind der folgenden Beschreibung zu entnehmen, in der die Erfindung anhand des in der Zeichnung dargestellten Ausführungsbeispiels näher beschrieben und erläutert ist.

Es zeigen:
- Figur 1: eine Beschichtungsanlage mit Beschichtungsstation und Trocknungsstation im Längsschnitt,
- Figur 2: die Trocknungsstation nach Figur 1,
- Figur 3: den Ausschnitt X einer ersten Prozess- und Zuluftheizstation nach Figur 1,
- Figur 4: den Ausschnitts Y einer zweiten Zuluftheizzone nach Figur 1,
- Figur 5: den Durchlauftrockner im Querschnitt,
- Figur 6: verschiedene Gebläseeinheiten in Draufsicht und
- Figur 7: ein Diagramm, das einen Temperaturverlauf der Platte sowie des Luftstromes über die Heizzonen und die Kühlzone wiedergibt.

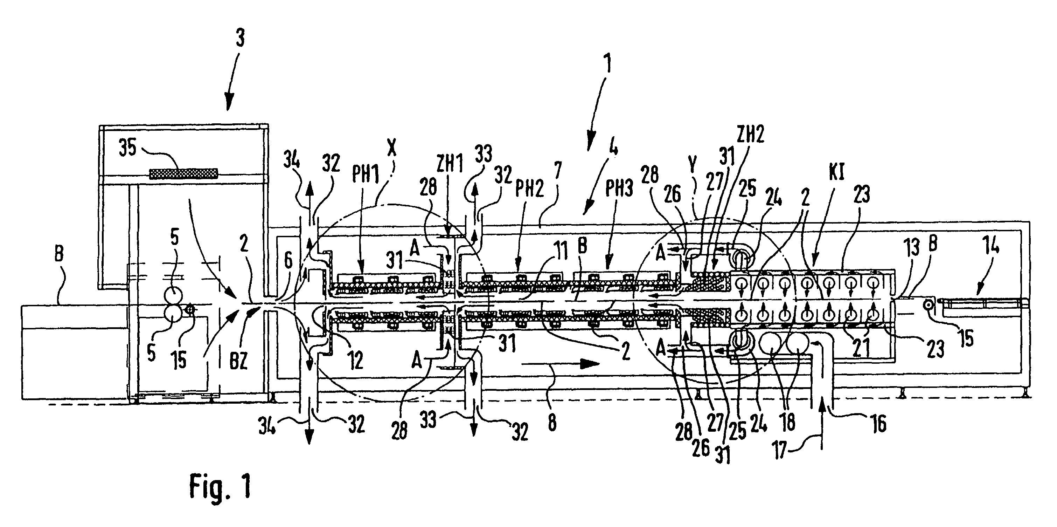

In der Figur 1 ist eine Beschichtungsanlage 1 für Platten 2, insbesondere für Innenlagen oder Leiterplatten dargestellt, die im Wesentlichen aus einer Beschichtungsstation 3 und einer Trocknungsstation 4 besteht. Die zu beschichtende Platte 2 wird hierbei entlang einer Transportbahn B von der linken Seite her in die Beschichtungsstation 3 eingeführt, wo die Platte 2 beidseitig über die beiden Beschichtungswalzen 5 mit insbesondere fotoempfindlichem Lack beschichtet wird. Nach der Beschichtung werden die Platten 2 entlang der Transportbahn B in Transportrichtung 8 aus der Beschichtungsstation 3 durch einen Durchgang 6 in die Trocknungsstation 4, die als Durchlauftrockner 7 ausgestaltet ist, transportiert. Die Beschichtungsanlage 1 weist in dem Bereich um den Durchgang 6 eine Beruhigungszone BZ auf, in der sich der Lack entspannt und homogenisiert. Die Beruhigungszone BZ erstreckt sich im Wesentlichen in dem Bereich zwischen den Beschichtungswalzen 5 und dem Kammereingang 12.

Der Durchlauftrockner 7 weist eine Trocknungskammer 11 mit einem Kammereingang 12 und einem Kammerausgang 13 sowie verschiedenen Heizzonen auf. Dabei ist zwischen Prozessheizzonen PH1, PH2 und PH3 sowie zwischen Zuluftheizzonen ZH1 und ZH2 zu unterscheiden. In der Transportbahn B, die im Wesentlichen horizontal verläuft, durchläuft die Platte 2 in Transportrichtung 8 zunächst die Prozessheizzone PH1, danach die Zuluftheizzone ZH1, daran anschließend die beiden Prozessheizzonen PH2 und PH3 sowie letztendlich die Zuluftheizzone ZH2. Im Anschluss daran ist in dem Durchlauftrockner 7 eine Kühlzone KI vorhanden, in welcher die Platte 2 gekühlt wird. Durch den Kammerausgang 13 wird die Platte 2 einem Plattenabnehmer 14 zugeführt, welcher die beschichteten und getrockneten Platten 2 hinter der Trocknungsstation 4 abstapelt bzw. einer nachfolgenden, nicht dargestellten, Belichtungs- und Ätzstation übergibt.

In der Figur 1 sind außerdem zwei senkrecht zur Transportbahn B angeordnete Kettenräder 15 gezeigt, welche zur Führung einer in dieser Figur nicht dargestellten Transportkette vorgesehen sind, entlang der die Platten 2 durch die Beschichtungsstation 3 und den Durchlauftrockner 7 transportiert werden.

Die Trocknungsstation 4 weist im Bereich der Kühlzone KI einen Einlass 16 auf, durch welchen ein Luftstrom 17 über Ansaugstutzen 18 in die Kühlzone KI geführt wird. In der Kühlzone KI sind dabei Verteilerrohre 21 und Luftschächte 23 vorhanden, die den die Platten 2 kühlenden Luftstrom zu- und abzuführen. Mittels Gebläseeinheiten 24 wird der der Kühlzone KI abgeführte Luftstrom 25 einer Luftweiche 26 zugeführt, die den Luftstrom 25 in zwei Luftströme 27 und 28 aufteilt. Die beiden Luftströme 27 und 28 werden dann der Trocknungskammer 11 an verschiedenen Stellen, nämlich an der Zuluftheizzone ZH1, was durch die Buchstaben A angedeutet ist, und der Zuluftheizzone ZH2, zugeführt.

Der Durchlauftrockner 7 weist mehrere Auslasse 32 auf, durch welche die der Trocknungskammer 11 abgeführte Luft der Abluft zugeführt wird. Die der Prozessheizzone PH2 und PH3 abgeführte Luft ist dabei mit einem Pfeil 33 symbolisiert dargestellt. Ein anderer der Abluft zugeführter Luftstrom 34 setzt sich aus Luft, die der Prozessheizzone PH1 abgeführt wird, und aus Luft, die aus der Beruhigungszone BZ abgesaugt wird, zusammen. Dazu sieht die Beschichtungsvorrichtung 3 einen Lufteinlass 35 mit einem entsprechenden Filter vor, durch welchen Frischluft angesaugt und die über die Beruhigungszone BZ entlang den frisch beschichteten Platten 2 durch den Durchgang 6 in den der Abluft zugeführten Luftstrom 34 geführt wird.

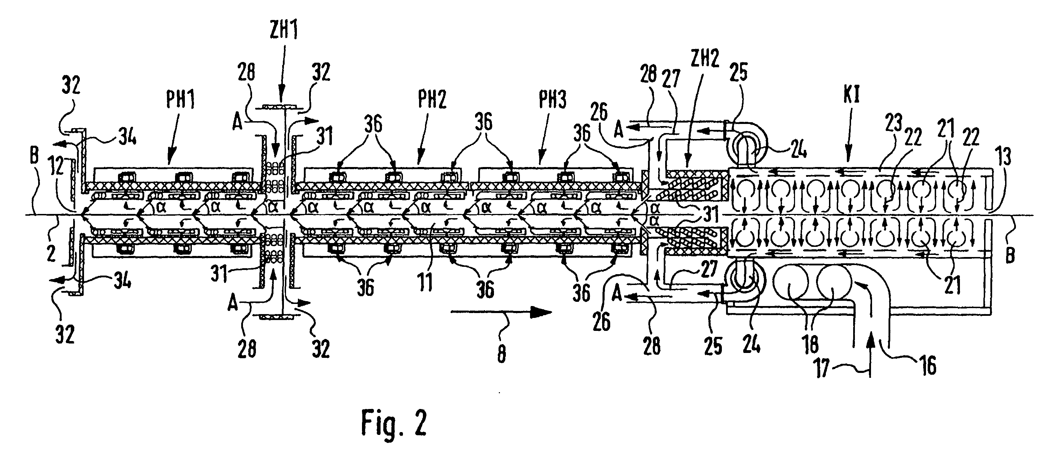

Um den Trocknungsvorgang in der Trocknungskammer 11 zu verdeutlichen, sind in den Figuren 2 - 6 verschiedene Ausschnitte und Details entsprechend der Figur 1, insbesondere nach den Ausschnitten X und Y, dargestellt.

In der Figur 2 ist die Trocknungskammer 11 mit den Heizzonen PH1, PH2, PH3, ZH1 und ZH2 sowie der Kühlzone KI gezeigt. An der Kühlzone KI sind deutlich die beiden Ansaugstutzen 18 zu erkennen, durch welche der Luftstrom 17 über den Lufteinlass 16 angesaugt wird. Hinter den Ansaugstutzen 18 sind nicht zu sehende Luftfiltersysteme vorgesehen, welche insbesondere für Reinluftbedingungen in der Trocknungskammer 11 sorgen.

Der Luftstrom 17 wird dann zur Kühlung der Platten 2 über die Verteilerrohre 21 auf die Platten 2 geblasen, was durch Pfeile 22 angedeutet wird. Der an den Platten 2 abströmende Luftstrom wird in den Luftschächten 23 gesammelt und den beiden Gebläseeinheiten 24 zugeführt, die die Luft aus der Kühlzone KI absaugen. Der so abgesaugte Luftstrom 25 wird an den T-stückartigen Luftweichen 26 in die beiden Luftströme 27 und 28 aufgeteilt. Der Luftstrom 27 wird dabei der Zuluftheizung ZH2 zugeführt, wo er über Heizregister 31 geführt und erhitzt wird. Danach wird er in der Trocknungskammer 11 auf die Platten 2 unter einem Anblaswinkel α von vorzugsweise 60°-45° bezüglich der Transportbahn B entgegen der Transportrichtung 8 auf die Platte 2 aufgeblasen. Der andere Luftstrom 28 wird der Zuluftheizzone ZH1 zugeführt, was durch die beiden Buchstaben A verdeutlicht werden soll, wo er ebenfalls über Heizregister 31 erwärmt und in der Trocknungskammer 11 unter dem Anblaswinkel α auf die Platten 2 geblasen wird. Im Weiteren wird der Luftstrom 27 in Teilluftströmen in den Prozessheizzonen PH3 und PH2 insgesamt 6-mal nacheinander, und zwar jeweils ober- und unterhalb der Transportbahn B, auf die Platte 2 unter dem Anblaswinkel α aufgeblasen. Dazu sind zwölf Gebläseeinheiten 36 vorgesehen, die in den nachfolgenden Figuren näher beschrieben werden.

Auf der dem Kammereingang zugewandten Seite der Prozessheizzone PH2 wird die in der Prozessheizzone PH2 vorhandene Luft über die beiden Auslasse 32 der Abluft zugeführt.

Der an der Luftweiche 26 abgeteilte Luftstrom 28 wird der Zuluftheizzone ZH1 zugeführt und dort, wie bereits zu Figur 1 beschrieben, über die Heizregister 31 erwärmt. Daran anschließend wird er unter dem Anblaswinkel α auf die Platte 2 geblasen. In der aus sechs Gebläseeinheiten 36 bestehenden Prozessheizzone PH1 wird entsprechend der Prozessheizzone PH2 und PH3 der Luftstrom 3-mal nacheinander unter dem Anblaswinkel α von oben und unten auf die Platten bzw. auf die Transportbahn geblasen. Auf der dem Kammereingang 12 zugewandten Seite der Prozessheizzone PH1 wird der Teilluftstrom 34 über die Auslasse 32 der Abluft zugeführt.

In Figur 1, wie auch in Figur 2, ist deutlich zu erkennen, dass die einzelnen Prozessheizzonen mehrere ober- und unterhalb entlang der Transportbahn B, parallel und spiegelbildlich der Transportbahn B angeordnete Gebläseeinheiten 36 aufweisen.

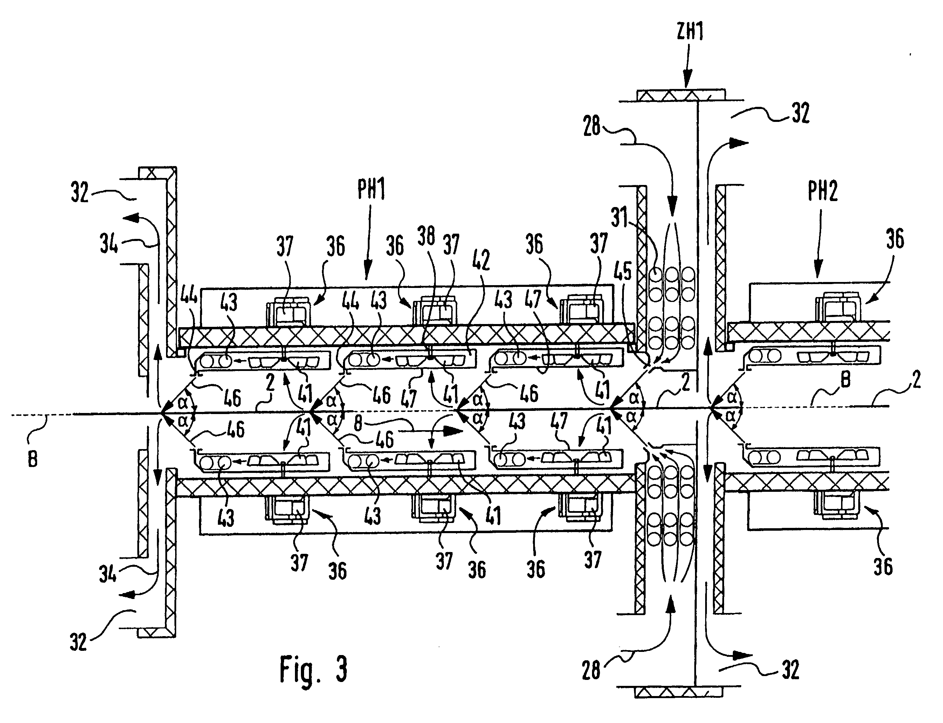

In der Figur 3 ist der Ausschnitt X nach Figur 1 vergrößert dargestellt. Deutlich zu erkennen ist die Prozessheizzone PH1 sowie die Zuluftheizzone ZH1. Die einzelnen in der Prozessheizzone PH1 angeordneten Gebläseeinheiten 36 weisen dabei jeweils einen Antriebsmotor 37, sowie einen auf der der Platten 2 zugewandten Seite vorhandenen, um eine Drehachse 38 des Antriebsmotors 37 drehbaren, Ventilator 41 auf. Die Drehachse 38 ist dabei senkrecht zur Transportbahn B angeordnet. Außerdem sind die Ventilator 41 von je einem Ventilatorengehäuse 42 umgeben. Alternativ dazu kann vorgesehen sein, dass die einzelnen, nebeneinander angeordneten Ventilatorengehäuse 42 zu einem Ventilatorengehäuse zusammen gefasst werden, welches dann für die einzelnen Ventilatoren 41 unterschiedliche Abteilungen vorsieht.

In den Ventilatorengehäusen 42 ist jeweils ein Heizelement, nämlich ein Elektroheizelement 43, vorhanden.

Die Ventilatorengehäuse 42 weisen außerdem in dem dem Kammereingang 12 zugewandten Bereich unterhalb der Elektroheizelemente 43 einen Spalt 44 auf, der quer zur Transportrichtung B, vorzugsweise unter einem Winkel von 90°, verläuft. Der Spalt 44 ist dabei weitgehend parallel zu der Transportbahn B und deckt in seiner Längsausdehnung die Breite der Transportbahn B voll ab. Dadurch ist gewährleistet, dass der Teilluftstrom, der durch den Spalt 44 geführt wird, über die gesamte Breite der Transportbahn B auf die Platte 2 bläst. Durch die geometrische Ausgestaltung der Spalte 44 wird der durch die Pfeile angedeutete Teilluftstrom 46 unter einem Anblaswinkel α, der vorzugsweise 60°-45° bezüglich der Transportbahn B entgegen der Transportrichtung 8 auf die Platte 2 beträgt, auf die Platten 2 geblasen.

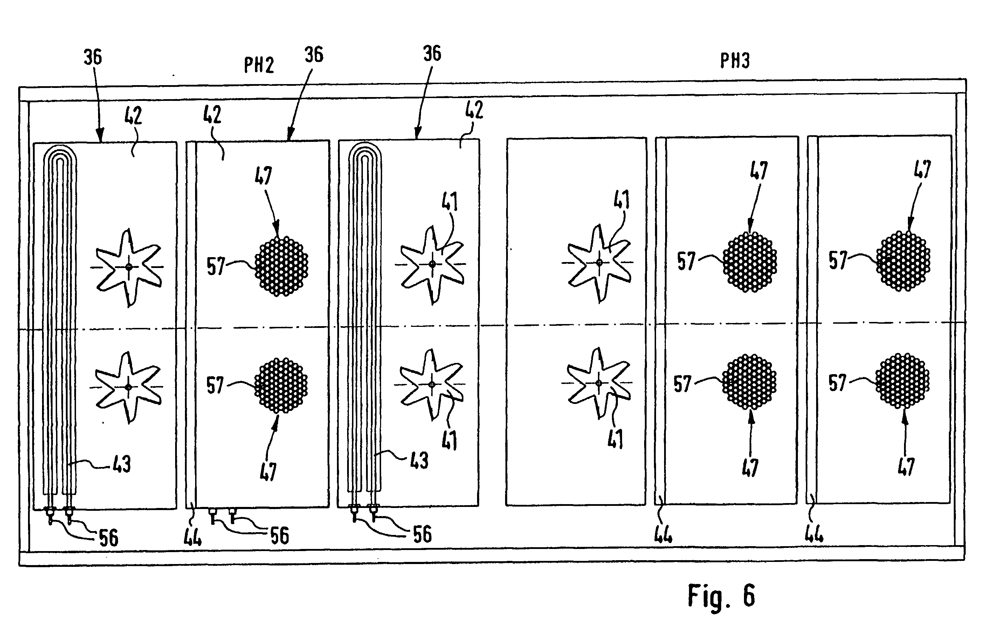

Die Ventilatorengehäuse 42 weisen außerdem an ihrer der Transportbahn B zugewandten Seite im Bereich um die Drehachse 38 der Ventilatoren 41 einen Lufteinlass 47 zum Einlass der durch die Ventilatoren 41 angesaugten Luft auf. Die Lufteinlasse 47 sind insbesondere in Figur 6 deutlich zu erkennen.

Die in der Figur 3 gezeigten Elektroheizelemente 43 zur Aufheizung des in der Prozessheizzone PH1 vorhandenen Luftstroms sind innerhalb der Ventilatorengehäuse 42 über die Länge des Spalts 44 angeordnet. Aufgrund der Ventilatorendrehung bildet sich über dem Spalt 44 ein Luftrückstau, der durch die Elektroheizelemente 43 erhitzt wird. Vorteilhafterweise sind über dem Spalt 44 Luftgleichrichter vorhanden, die den sich über dem Spalt 44 bildenden Luftrückstau gleichmäßig über die gesamte Längsausdehnung des Spaltes 44 verteilen, und eine gleichmäßige Geschwindigkeits- und Temperaturverteilung sowie Beschleunigung eines aus dem Spalt 44 austretenden Teilluftstromes 46 zu gewährleisten. Erfindungsgemäß werden als Elektroheizelemente 43 Rippenheizelemente verwendet, deren Rippen als Luftgleichrichter ausgebildet sind.

In einer anderen Ausführungsform der Erfindung ist denkbar, dass zusätzlich bzw. auch alternativ zu den Elektroheizelementen 43 eine Erhitzung der Platte 2 mittels Infrarotstrahlern erfolgt. Die Infrarotstrahler können dabei links und rechts neben den Lufteinlassen 47 an den Ventilatorengehäusen 42 angeordnet sein, und die Platten 2 bzw. die Transportbahn B unmittelbar mit Wärmestrahlung bestrahlen.

In Figur 3 wird auch deutlich, dass der von dem einem Ventilator 41 auf die Platte 2 geblasene Teilluftstrom 46 von dem entgegen Transportrichtung 8 liegenden benachbarten Ventilator angesaugt und an anderer, entgegen der Transportrichtung liegenden Stelle, erneut auf die Platte 2 aufgeblasen wird.

Außerdem ist der Figur 3 zu entnehmen, dass die Platte 2 mit weitgehend paralleler, zu der Transportrichtung 8 quer verlaufender, Teilluftströme 46 unter dem Anblaswinkel α angeblasen wird. Durch Hintereinanderschaltung mehrerer Gebläseeinheiten 36 wird die Bildung einer wellenartigen Luftbewegung innerhalb der Trocknungskammer 11 erreicht. Diese Wellenbewegung entsteht durch wiederholtes Blasen des Teilluftstromes 46 durch die Spalte 44 unter dem Anblaswinkel α auf die Platte 2 und daran anschließendes Absaugen des an der Platte 2 abströmenden entsprechenden Teilluftstromes 46 mittels eines Ventilators 41 sowie wiederholtes Aufblasen auf die Platte 2. Dadurch wird insbesondere auch das Entstehen einer laminaren Grenzschicht entlang der Oberfläche der Platte 2 verhindert. Es findet erfindungsgemäß eine zwangsgeführte und definierte Anblasung der Platte 2 mittels "Luftmessern" bzw. den Teilluftströmen 46, durch die Spalte 44 statt. Dadurch wird ein schnelles und intensives Trocknen der beschichteten Platten 2 ermöglicht.

Im rechten Abschnitt der Figur 3 ist die Prozessheizzone PH2 abschnittsweise erkennbar. Die in der Prozessheizzone PH2 vorhandenen Gebläseeinheiten 36 entsprechen im Aufbau und in der Funktion den zur Prozessheizzone PH1 erläuterten Gebläseeinheiten 36.

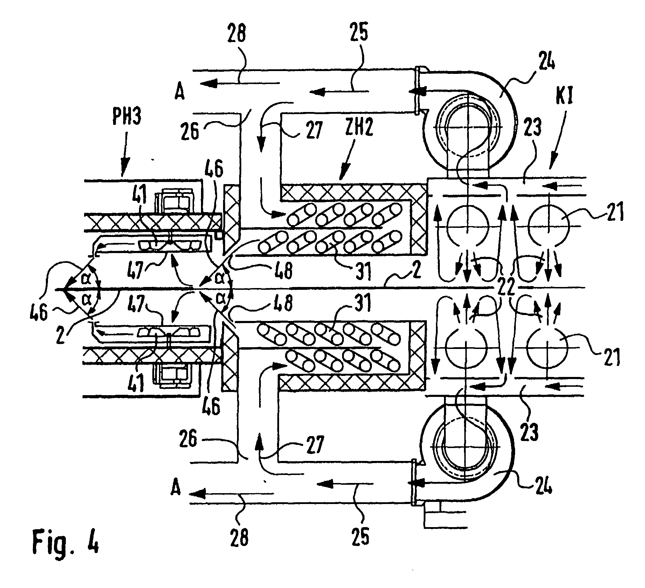

In der Figur 4 ist der Ausschnitt Y nach Figur 1 vergrößert dargestellt. Im rechten Bereich der Figur 4 ist die Kühlzone KI abschnittsweise zu erkennen. Im mittleren Bereich der Figur 4 ist die Zuluftheizzone ZH2 und im linken Bereich ein Ausschnitt der Prozessheizzone PH 3 dargestellt. Dabei ist deutlich zu erkennen, wie der aus der Kühlzone KI über die Gebläseeinheit 24 abgeführte Luftstrom 25 an der Luftweiche 26 in die beiden Luftströme 28 und 27 aufgeteilt wird. Der Luftstrom 27 wird dabei der Zuluftheizung ZH2 zugeführt, wo er über mehrere Heizregister 31 geführt und an diesen erhitzt wird. Schließlich wird der Luftstrom 27 über einen Spalt 48 auf die Platte 2 bzw. auf die Transportbahn B unter dem Winkel α, der vorzugsweise 60°-45° bezüglich der Transportbahn B entgegen der Transportrichtung 8 beträgt, geblasen. Die an der Platte 2 abströmende Luft wird dabei von den in der Prozessheizzone PH3 vorhandenen Ventilatoren 41 über deren Lufteinlass 47 angesaugt und an anderer Stelle, entgegen der Transportrichtung 8, auf die Transportbahn B bzw. auf die Platte 2 unter dem Winkel α geblasen.

Wie in Figur 4 deutlich zu erkennen ist, sind in den Ventilatorengehäusen 42 der Prozessheizzone PH 3 keine Elektroheizelemente 43 vorhanden. Durch die starke Aufhitzung des Teilluftstromes 27 in der Zuluftheizzone ZH2 kann auf eine erneute Aufheizung des Luftstroms in der Prozessheizzone PH3 verzichtet werden.

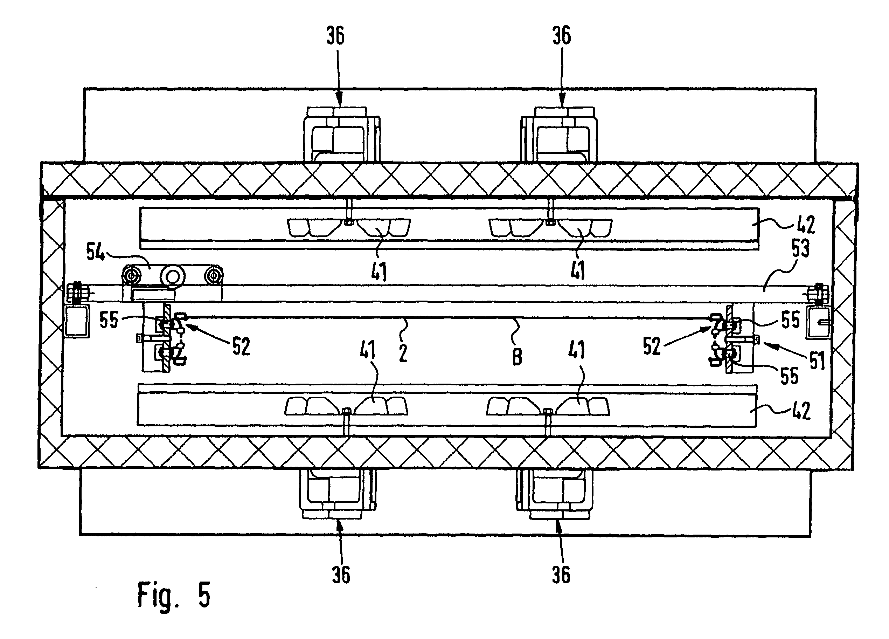

In der Figur 5 ist ein Querschnitt durch eine Prozessheizzone gezeigt. Dabei sind ober- und unterhalb der Transportbahn B vier Gebläseeinheiten 36 vorhanden. Die Ventilatoren 41 der Gebläseeinheiten 36 sind dabei in dem Ventilatorengehäuse 42 untergebracht. Die Platte 2 ist zum Transport durch die Trocknungskammer 11 in ein Transportmittel 51 mittels Klemmhaken 52 eingespannt. Das Transportmittel 51 weist dabei einen Querbalken 53 auf, auf welchem ein Schlitten 54 verfahrbar angeordnet ist. Dadurch kann das Transportmittel 51 an die Breite der zu trocknenden Platten 2 angepasst werden. Die Klemmhaken 52 sind an Transportketten 55 angeordnet, die über einen Kettenstransport mit den in der Figur 1 dargestellten Kettenrädern 15 angetrieben wird. Die Kettenrädern 15 sind dabei in einer zu der Transportbahn B senkrechten Ebene angeordnet.

In der Figur 6 sind die beiden Prozessheizzonen PH2 und PH3 in Ansicht von der Transportbahn B dargestellt. Das linke und das rechte Ventilatorengehäuse 42 der Prozessheizzone PH2 ist dabei im Schnitt dargestellt, so dass die jeweils beiden, in den Ventilatorengehäusen 42 vorhandenen, Ventilatoren 41 sichtbar sind. Außerdem ist bei diesen beiden Gebläseeinheiten 36 das Elektroheizelement 43, das sich über die gesamte Breite der Ventilatorengehäuse 34 und damit der Transportbahn B erstreckt, deutlich zu erkennen. Das Elektroheizelement 43 ist dabei als Rippenheizkörper ausgebildet, dessen Rippen als Luftgleichrichter ausgebildet sind. An den Ventilatorengehäusen 42 der Prozessheizzone PH2 sind außerdem Heizelementstutzen 56 zum Anschluss der Elektroheizelemente 43 vorhanden.

Das mittlere Ventilatorengehäuse 42 der Prozessheizzone PH2 ist geschlossen gezeigt. Dabei sind die beiden Lufteinlasse 47, nämlich Metallgitter 57, zu sehen, durch welches die Ventilatoren 41 Teilluftströme in die Ventilatorengehäuse 42 saugen. Deutlich zu sehen ist auch der Spalt 44, durch welchen die Teilluftströme unter einem Anblaswinkel α auf die Platte 2 geblasen werden. Der Spalt 44 deckt dabei in Längsausdehnung die Breite der Transportbahn B voll ab.

In den Ventilatorengehäusen 42 der Prozessheizzone PH3 sind, wie in Figur 6 zu erkennen ist, keine Heizelemente vorhanden. Die linke Gebläseeinheit 36 der Prozessheizzone PH3 ist dabei im Schnitt gezeigt, so dass die beiden Ventilatoren 41 sichtbar sind. Bei den anderen Ventilatorengehäusen 42 der Prozessheizzone PH3 sind die Lufteinlasse 47 in Form von Metallgittern 57 sowie die Spalte 44 deutlich zu sehen.

Bei der in den Figuren 1 - 6 gezeigten Trocknungskammer 11 mit den verschiedenen Heizzonen PH1, PH2, PH3, ZH1 und ZH2 heizt die Prozess- und Zuluftheizzone PH1 und ZH1 die Platte 2 auf. In den weiteren Heizzonen PH2, PH3 und ZH2 wird die Platte 2 weitgehend auf der in der ersten Prozess- und Zuluftheizzone PH1 und ZH1 aufgeheizten Temperatur gehalten. Dazu sind in der Prozessheizzone PH2 in den jeweiligen Ventilatorengehäusen 42 die Elektroheizelemente 43 vorhanden. In der Prozessheizzone PH3 hingegen wird auf solche Elektroheizelemente 43 verzichtet, da die in die Prozessheizzone PH3 eingeblasene Luft zuvor über die Zuluftheizzone ZH2 entsprechend erhitzt wird. Durch die relativ schnelle, intensive und gleichmäßige Erhitzung der Platte 2 in der ersten Prozess- und Zuluftheizzone PH1 und ZH1 kann die Platte 2 in den weiteren Heizzonen PH2, PH3 und ZH2 mit einer relativ hohen Luftgeschwindigkeit angeblasen werden, was eine schnelle und gute Trocknung der Beschichtung zur Folge hat.

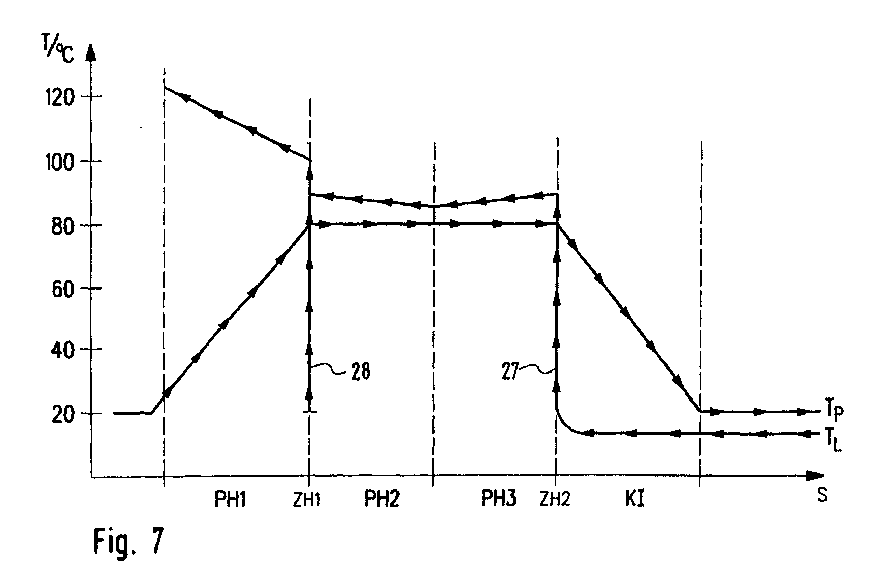

In dem Diagramm nach Figur 7 ist qualitativ ein möglicher Temperaturverlauf der Platte T_{P} sowie des Luftstroms T_{L} über die verschiedenen Heizzonen und die Kühlzone wiedergegeben.

Folgt man dem Temperaturverlauf Tp der Platte 2 von links nach rechts, so ist über der Prozessheizzone PH1 ein deutlicher Temperaturanstieg der Platte 2 von ca. 20° auf über 80° zu erkennen. In der Zuluftheizzone ZH1 sowie den beiden Prozessheizzonen PH2 und PH3 wird die Platte 2 weitgehend auf konstanter Temperatur gehalten. Die daran anschließende Abkühlung der Platte 2 von der Betriebstemperatur auf die Weiterverarbeitungstemperatur von unter 30°C erfolgt in der Kühlzone KI.

Da der Luftstrom in dem Durchlauftrockner 7 der Transportrichtung 8 entgegengerichtet ist, ist dem Temperaturverlauf des Luftstroms T_{L} von rechts nach links zu folgen. Der Luftstrom 17 wird dabei mit einer Temperatur von ca. 20° in die Kühlzone KI geblasen. Dabei erwärmt sich der Luftstrom 17 in der Kühlzone KI minimal, so dass er mit einer Temperatur von etwas über 20°C als Luftstrom 27 und 28 in die beiden Heizzonen ZH1 und ZH2 geblasen wird. In der Zuluftheizzone ZH2 wird der Luftstrom 27 auf eine Temperatur von ca. 100°C erhitzt. Der Luftstrom 27 wird dann in der Prozessheizzone PH3 nicht weiter erhitzt. In der Prozessheizzone PH2 wird der Luftstrom 27 durch in dieser Prozessheizzone vorhandene Elektroheizelemente 43 auf ca. 100°C gehalten. Der der Zuluftheizzone ZH1 zugeführte Luftstrom 28 wird über die dort vorhandene Heizregister auf ca. 100°C erhitzt, und mit dieser Temperatur der Prozessheizzone PH 1 zugeführt. Aufgrund der in der Prozessheizzone PH1 vorhandenen weiteren Heizelemente wird der Luftstrom 28 weiter erhitzt, so dass dessen Temperatur beim Austritt aus der Heizzone PH1 ca. 120°C beträgt.

Die erfindungsgemäße Beschichtungsanlage, der erfindungsgemäße Durchlauftrockner 7 und das erfindungsgemäße Trocknungsverfahren ermöglichen eine sehr kurze Durchlaufzeit bzw. eine sehr schnelle Trocknung der zu trocknenden nassbeschichteten Platte 2. Der auf die Platte 2 geblasene Teilluftstrom 46 hat dabei eine Geschwindigkeit von ca. 10 m/s, die Temperatur der aufgeblasenen Luft liegt, je nach Ausführungsform, bei ca. 60 bis 125°C. Als Elektroheizelemente 43 finden insbesondere sog. Rohr- und/oder Rippenheizkörper Verwendung, die jeweils eine Leistung von ca. 1500 Watt bzw. eine Oberflächentemperatur von ca. 300°C aufweisen. Der Abstand der Ventilatoren 41 zu der Transportbahn B bzw. zu der Platte 2 beträgt, abhängig von der Ausführungsform, zwischen 50 und 100 mm. Die beschichteten Platten 2 verlassen die Beschichtungsstation 3 mit einer Nassfilmdicke des Lacks von 5 - 100 Mikrometern. Die in der Trocknungskammer 11 verwendeten Heizregister 31 haben eine Heizleistung von vorzugsweise 18 - 27 Kilowatt, je nach Ausführungsform des Durchlauftrockners 7. Die der Trocknungskammer 11 zugeführte Luft 17 weist eine Temperatur von ca. 20°C auf, die der Trocknungsanlage abgeführte Luftstrom 33 u. 34 ca. 120°C. Bei den in der ersten Prozessheizzone PH1 verwendbaren Infrarotstrahlern handelt es sich vorzugsweise um langwellige Quarzstrahler, die eine Leistung von 800 Watt und eine Oberflächentemperatur von ca. 300°C aufweisen.

## Patentansprüche

1. Durchlauftrockner (7) für beschichtete Platten (2) oder Bahnen, insbesondere für Leiterplatten oder Innenlagen, mit einer Trocknungskammer (11), mit die Platte (2) oder Bahn entlang einer Transportbahn (B) in Transportrichtung (8) durch die Trocknungskammer (11) von einem Kammereingang (12) zu einem Kammerausgang (13) transportierenden Transportmitteln (51), mit einem in der Trocknungskammer (11) entgegen der Transportrichtung (8) zwangsgeführten Luftstrom, mit einem Einlass (16, 35) und einem Auslass (32) des Luftstromes, mit Gebläseeinheiten (36) zur Erzeugung des Luftstromes und mit Heizelementen zur Aufheizung des Luftstromes, **dadurch gekennzeichnet, dass** die Gebläseeinheiten (36) ober- und/oder unterhalb entlang der Transportbahn (B) parallel zur Transportbahn (B) angeordnet sind, dass die Gebläseeinheiten (36) jeweils einen zu der Transportrichtung (8) quer, vorzugsweise unter einem Winkel von 90°, gelegenen Spalt (44) aufweisen und dass Teilluftströme (46) des Luftstroms durch die Spalte (44) unter einem Anblaswinkel (α) von 90° bis 15°, vorzugsweise 60° bis 45°, bzgl. der Transportbahn (B) entgegen der Transportrichtung (8) auf die Platte (2) oder Bahn bzw. auf die Transportbahn (B) geblasen werden, und dass bei zwei entlang der Transportbahn (B) nebeneinander liegenden Gebläseeinheiten (36) die dem Kammereingang (12) näher gelegene Gebläseeinheit (36) den von der dem Kammereingang (12) entfernt gelegenen Gebläseeinheit (36) auf die Platte (2) oder Bahn geblasenen und an der Platte (2) oder Bahn abströmenden Teilluftstrom (40, 36) wenigstens teilweise ansaugt und auf die Platte (2) oder Bahn bzw. auf die Transportbahn (B) an anderer Stelle aufbläst.

2. Durchlauftrockner (7) nach Anspruch 1, **dadurch gekennzeichnet, dass** die Gebläseeinheiten (36) spiegelbildlich zur Transportbahn (B) ober- und unterhalb der Transportbahn (B) angeordnet sind.

3. Durchlauftrockner (7) nach einem der Ansprüche 1 bis 2, **dadurch gekennzeichnet, dass** die Platte (2) oder Bahn von mehreren, hintereinander, parallel zueinander angeordneten Teilluftströmen (46) unter dem Anblaswinkel (α) von 90° bis 15°, vorzugsweise 60° bis 45°, angeblasen werden.

4. Durchlauftrockner (7) nach einem der vorhergehenden Ansprüche, **dadurch gekennzeichnet, dass** der Spalt (44) weitgehend parallel zur Transportbahn (B) verläuft und in Längsausdehnung die Breite der Transportbahn (B) voll abdeckt.

5. Durchlauftrockner (7) nach einem der vorhergehenden Ansprüche, **dadurch gekennzeichnet, dass** auf der der jeweiligen Gebläseeinheit (36) zugewandten Seite des Spalts (44) Luftgleichrichter vorhanden sind, die eine gleichmäßige Temperatur-, Geschwindigkeitsverteilung und Beschleunigung des jeweiligen Teilluftstromes (46) bewirken.

6. Durchlauftrockner (7) nach einem der vorhergehenden Ansprüche, **dadurch gekennzeichnet, dass** die Gebläseeinheiten (36) um eine Drehachse (38) drehbare Ventilatoren (41) aufweisen und die Drehachse (38) senkrecht zu der Transportbahn (B) verläuft.

7. Durchlauftrockner (7) nach Anspruch 6, **dadurch gekennzeichnet, dass** die Ventilatoren (41) im Bereich der Drehachse (38) Luft aus der Trocknungskammer (11) (7) ansaugen.

8. Durchlauftrockner (7) nach Anspruch 6 oder 7, **dadurch gekennzeichnet, dass** die Ventilatoren (41) in Ventilatorengehäusen (42) angeordnet sind, die einen Spalt (44) nach Anspruch 1 aufweisen.

9. Durchlauftrockner (7) nach Anspruch 8, **dadurch gekennzeichnet, dass** die Ventilatorengehäuse (42) an ihrer der Transportbahn (B) zugewandten Seite im Bereich der Drehachse (38) zum Einlass der anzusaugenden Luft einen Lufteinlass (47) aufweisen.

10. Durchlauftrockner (7) nach Anspruch 9, **dadurch gekennzeichnet, dass** der Lufteinlass (47) ein Metallgitter (57) ist.

11. Durchlauftrockner (7) nach einem der Ansprüche 6 bis 10, **dadurch gekennzeichnet, dass** die Ventilatorengehäuse (42) in dem dem Kammereingang (12) zugewandten Bereich den Spalt (44) aufweisen.

12. Durchlauftrockner (7) nach einem der Ansprüche 6 bis 11,
**dadurch gekennzeichnet, dass** die Heizelemente an und/oder innerhalb der Ventilatorengehäusen (42) angeordnet sind.

13. Durchlauftrockner (7) nach einem der vorhergehenden Ansprüche, **dadurch gekennzeichnet, dass** die Heizelemente Elektroheizelemente (43) und/oder Infrarotstrahler sind.

14. Durchlauftrockner (7) nach einem der Ansprüche 6 bis 13, **dadurch gekennzeichnet, dass** die Elektroheizelemente (43) innerhalb der Ventilatorengehäuse (42) entlang des Spaltes (44) über dem Spalt (44) angeordnet sind.

15. Durchlauftrockner (7) nach Anspruch 14, **dadurch gekennzeichnet, dass** die Elektroheizelemente (43) Rippenheizelemente sind, deren Rippen als Luftgleichrichter nach Anspruch 5 ausgebildet sind.

16. Durchlauftrockner (7) nach einem der vorhergehenden Ansprüche, **dadurch gekennzeichnet, dass** die Trocknungskammer (11) mehrere Heizzonen, insbesondere zwei Zuluftheizzonen (ZH1, ZH2) sowie drei Prozessheizzonen (PH1, PH2, PH3) aufweist.

17. Durchlauftrockner (7) nach Anspruch 16, **dadurch gekennzeichnet, dass** die erste Prozess- und Zuluftheizzone (PH1, ZH1) die Platte (2) oder Bahn aufheizt und die weiteren Heizzonen (PH2, PH3, ZH2) die Platte (2) oder Bahn weitgehend auf der in der ersten Prozess- und Zuluftheizzone (PH1, ZH1) aufgeheizten Temperatur halten.

18. Durchlauftrockner (7) nach Anspruch 16 oder 17, **dadurch gekennzeichnet, dass** die Prozessheizzonen (PH1, PH2, PH3) eine Gruppe von Gebläseeinheiten (36) mit oder ohne Heizelementen aufweisen.

19. Durchlauftrockner (7) nach einem der Ansprüche 16 bis 18, **dadurch gekennzeichnet, dass** die ersten beiden Prozessheizzone (PH1, PH2) Heizelemente aufweist und die weiteren Prozessheizzonen (PH3) keine Heizelemente aufweisen.

20. Durchlauftrockner(6) nach einem der Ansprüche 16 bis 19, **dadurch gekennzeichnet, dass** vor den Prozessheizzonen (PH1, PH2, PH3) Zuluftheizzonen (ZH1, ZH2) vorhanden sind, die die den Prozessheizzonen (PH1, PH2, PH3) zugeführte Luft aufheizen.

21. Durchlauftrockner (7) nach den Ansprüchen 16 bis 20, **dadurch gekennzeichnet, dass** den Heizzonen (PH1, PH2, PH3, ZH1, ZH2) eine Kühlzone (KI) nachgeschaltet ist.

22. Durchlauftrockner (7) nach Anspruch 21, **dadurch gekennzeichnet, dass** in der Kühlzone (KI) die Luft überwiegend senkrecht auf die Platte (2) oder Bahn bzw. die Transportbahn (B) geblasen wird.

23. Durchlauftrockner (7) nach einem der vorhergehenden Ansprüche, **dadurch gekennzeichnet, dass** an dem Einlass (16) des Luftstromes (17) an dem Durchlauftrockner (7) ein Reinluftfilter vorgesehen ist.

24. Beschichtungsanlage (1) zum Beschichten von Platten (2) oder Bahnen, insbesondere von Leiterplatten oder Innenlagen, mit einer Beschichtungsstation (3), in der die Platte (2) oder Bahn ein- oder beidseitig mit Lack beschichtet wird und mit einer daran anschließenden Trocknungsstation (4), in der der Lack getrocknet und im Lack enthaltenes Lösungsmittel abgedampft und weggeführt wird, **dadurch gekennzeichnet, dass** die Trocknungsstation (4) einen Durchlauftrockner (7) gemäß einem der vorhergehenden Ansprüche aufweist.

25. Beschichtungsanlage (1) nach Anspruch 24, **dadurch gekennzeichnet, dass** zwischen der Beschichtungsstation (3) und der Trocknungsstation (4) eine Beruhigungszone (βZ) vorhanden ist, in der sich der Lack entspannt und homogenisiert.

26. Beschichtungsanlage (1) nach Anspruch 25, **dadurch gekennzeichnet, dass** der Trocknungsstation (4) eine Belichtungs- und Ätzstation nachgeschaltet ist.

27. Verfahren zum Trocknen von beschichteten Platten (2) oder Bahnen, insbesondere von beschichteten Innenlagen oder Leiterplatten, **gekennzeichnet durch** folgende Verfahrensschritte:
- Führen der Platte (2) oder Bahn entlang einer Transportbahn (B) in Transportrichtung (8) **durch** eine Trocknungskammer (11),
- Aufheizen und entgegen der Transportrichtung (8) Zwangsführen eines in der Trocknungskammer (11) vorhandenen, mehrere Teilluftströme (46) aufweisenden Luftstromes (14),
- Anblasen der Platte (2) oder Bahn mit weitgehend paralleler, zu der Transportrichtung (8) quer verlaufender, Teilluftströme (46) unter einem Anblaswinkel (α) von 90° bis 15°, vorzugsweise 60° bis 45°, bzgl. der Transportbahn (B) entgegen der Transportrichtung (8) der Platte (2) oder Bahn und
- Trocknung der Beschichtung aufgrund der Anblasung der Platte (2) oder Bahn mit den heißen Teilluftströmen (46), wobei die auf die Platte (2) oder Bahn geblasene und an der Platte (2) oder Bahn abströmenden Teilluftströme (46) jeweils abgesaugt und an einer entgegen der Transportrichtung (8) jeweils anderen Stelle auf die Transportbahn (B) bzw. auf die Platte (2) oder Bahn derart aufgeblasen werden, dass in der Trocknungskammer (11) eine wellenartige Luftbewegung erreicht wird.

28. Verfahren nach Anspruch 27, **dadurch gekennzeichnet, dass** die Teilluftströme (46) spiegelbildlich zur Transportbahn (B) von ober- und unterhalb der Transportbahn (B) auf die Transportbahn (B) bzw. die Platte (2) oder Bahn blasen.

29. Verfahren nach einem der Ansprüche 27 bis 28, **dadurch gekennzeichnet, dass** die die Platte (2) oder Bahn anblasenden Teilluftströme (46) die Platte (2) oder Bahn über ihre gesamte Breite anblasen.

30. Verfahren nach einem der Ansprüche 27 bis 28, **dadurch gekennzeichnet, dass** das Aufheizen des Luftstromes (27, 28) und/oder der Teilluftströme (46) über Heizelemente, insbesondere Elektroheizelemente (42), erfolgt.

31. Verfahren nach einem der Ansprüche 27 bis 30, **dadurch gekennzeichnet, dass** die Trocknung in verschiedenen Heizzonen (PH1, PH2, PH3, ZH1, ZH2) erfolgt.

32. Verfahren nach einem der Ansprüche 27 bis 30, **dadurch gekennzeichnet, dass** in einer ersten Prozessheizzone und Zuluftheizzone (PH1, ZH1) die Platte (2) oder Bahn schnell und intensiv erhitzt wird.

33. Verfahren nach einem der Ansprüche 27 bis 32, **dadurch gekennzeichnet, dass** die schnelle und intensive Erhitzung mittels der auf die Platte (2) oder Bahn aufgeblasenen heißen Teilluftströme (46) und/oder mittels Wärmestrahlung, insbesondere Infrarotstrahlung, erfolgt.

34. Verfahren nach einem der Ansprüche 27 bis 33, **dadurch gekennzeichnet, dass** in den weiteren Heizzonen (PH2, PH3, ZH2) die Platte (2) oder Bahn weitgehend auf der in der ersten Prozessheizzone und Zuluftheizzone (PH1, ZH1) aufgeheizten Temperatur gehalten wird und die Austrocknung der Beschichtung durch die auf die Platte (2) oder Bahn aufgeblasenen heißen Teilluftströme (46) erfolgt.

35. Verfahren nach einem der Ansprüche 27 bis 34, **dadurch gekennzeichnet, dass** die Platte (2) oder Bahn in einer den Heizzonen (PH1, PH2, PH3, ZH1, ZH2) nachgeschalteten Kühlzone (KI) abgekühlt wird.

36. Verfahren nach einem der Ansprüche 27 bis 35, **dadurch gekennzeichnet, dass** die zur Kühlung vorgesehene Luft weitgehend senkrecht auf die Transportbahn (B) bzw. auf die Platte (2) oder Bahn aufgeblasen wird.

37. Verfahren nach einem der Ansprüche 27 bis 36, **dadurch gekennzeichnet, dass** die Trocknung unter Verwendung von Reinluft erfolgt.

## Claims

1. Continuous flow drier (7) for coated boards (2) or webs, particularly for printed circuit boards or inner plies, with a drying chamber (11), with a means of conveyance (51) for conveying the board (2) or web in a direction of transfer along a conveyor belt (B), from a chamber inlet (12) to a chamber outlet (13) through the drying chamber (11), with a forced induction airflow for guiding a stream of air against the direction of conveyance (8), with an inlet (16, 38) and an outlet (32) for the airflow, with fan units (36) for generating the stream of air and with heating elements for heating the stream of air, **characterised in that** the fan units (36) are positioned along and above and/or below the conveyor belt (B) and parallel to it, that each of the fan units (36) exhibits a slit (44) which cuts across the direction of transfer (8), preferably at an angle of 90°, and that partial air streams (46) are blown on to the board (2) or web, or on to the conveyor belt, and against the direction of transfer (B), through the gaps (44) at an airflow angle (α) of 90° to 15°, and preferably 60° to 45°, with respect to the conveyor belt (B), and that in the case of two adjoining fan units (36) positioned along the conveyor belt (B), the fan unit (36) closest to the chamber inlet (12) at least partially aspirates the partial airflow (40, 36) blown on to the board or web by the fan unit (36) that is remote from the chamber inlet (36), the air stream flowing off the board (2) or web, and blows this back again on to another part of the board (2) or web, or on to the conveyor belt, respectively.

2. Continuous flow drier (7) according to claim 1, **characterised in that** the fan units (36) are positioned in such a manner above and below the conveyor belt (B) that they are laterally reversed with respect to the conveyor belt (B).

3. Continuous flow drier (7) according to any one of claims 1 to 2, **characterised in that** several successive, partial air streams (46) are arranged parallel to each other so as to flow against the board (2) or web at an airflow angle (α) of 90° to 15°, and preferably 60° to 45°.

4. Continuous flow drier (7) according to any one of the preceding claims, **characterised in that** the slit (44) runs substantially parallel to the conveyor belt (B) and completely covers the width of the conveyor belt (B) in its lengthwise extent.

5. Continuous flow air drier (7) according to any one of the preceding claims, **characterised in that** flow straighteners are provided on the side of the slit (44) turned towards the respective fan unit (36), which bring about uniform temperature and speed distribution and acceleration of the respective partial air streams (46).

6. Continuous flow drier (7) according to any one of the preceding claims, **characterised in that** the fan units (36) feature fan blowers (41) which rotate about one axis of rotation (38) and that this axis of rotation (38) runs perpendicularly to the conveyor belt (B).

7. Continuous flow drier (7) according to claim 6, **characterised in that** the fan blowers (41) take in air from the drying chamber (11) in the proximity of the axis of rotation (38).

8. Continuous flow drier (7) according to claim 6 or 7, **characterised in that** the fan blowers (41 ) are located in fan casings (42) that exhibit a slit (44) in accordance with claim 1.

9. Continuous flow drier (7) according to claim 8, **characterised in that** on the side facing the conveyor belt, the fan casings (42) exhibit an air inlet (47) for the admission of air to be aspirated, in the proximity of the rotational axis.

10. Continuous flow drier (7) according to claim 9, **characterised in that** the air inlet (47) is a metal grid (57).

11. Continuous flow drier (7) according to any one of claims 6 to 11, **characterised in that** the fan casings (42) exhibit the slit (44) in the area facing the chamber inlet (12).

12. Continuous flow drier (7) according to any one of claims 6 to 12, **characterised in that** the heating elements are positioned on and/or within the fan casings (42).

13. Continuous flow drier (7) according to any one of the preceding claims, **characterised in that** the heating elements are electric heating elements (43) and/or infrared radiators.

14. Continuous flow drier (7) according to any one of claims 6 to 13, **characterised in that** the electric heating elements (43) arranged along the slit (44) within the fan casings (42) are positioned above the slit (44).

15. Continuous flow drier (7) according to claim 14, **characterised in that** the electric heating elements (43) are ribbed heating elements, the ribs of which are designed as flow straighteners in accordance with claim 5.

16. Continuous flow drier (7) in accordance with any one of the preceding claims, **characterised in that** the drying chamber (11) exhibits several heating zones, in particular two supply air heating zones (ZH1, ZH2), as well as three process heating zones (PH1, PH2).

17. Continuous flow drier (7) according to claim 16, **characterised in that** the first process and supply air heating zone (PH1, ZH1) heat the board or the web, and the other heating zones (PH2, PH3, ZH2) largely keep the board (2) or web at the temperature reached in the first process and supply air heating zone (PH1, ZH1).

18. Continuous flow drier (7) according to claim 16 or 17, **characterised in that** the process heating zones (PH1, PH2, PH3) exhibit a group of fan units (36) with or without heating elements.

19. Continuous flow drier (7) according to any one of claims 16 to 18, **characterised in that** the first two process heating zones (PH1, PH2) have heating elements and the other process heating zones (PH3) have no heating elements.

20. Continuous flow drier (7) according to any one of claims 16 to 19, **characterised in that** supply air heating zones (ZH1, ZH2) are provided in front of the process heating zones (PH1, PH2, PH3), which heat the fresh air supplied to the process heating zones (PH1, PH2, PH3).

21. Continuous flow drier (7) according to claims 16 to 20, **characterised in that** the heating zones (PH1, PH2, PH3, ZH1, ZH2) have a downstream cooling zone (KI).

22. Continuous flow drier (7) according to claim 21, **characterised in that** the air is blown substantially perpendicularly on to the board (2), or web, or conveyor belt (B), respectively, in the cooling zone (KI).

23. Continuous flow drier (7) according to any one of the preceding claims, **characterised in that** the continuous flow drier is provided with a clean air filter at the inlet (16) of the air stream (17).

24. Coating plant (1) for coating boards (2) or webs, particularly printed circuit boards or inner plies, with a coating unit (3) in which the board (2) or web is coated unilaterally or bilaterally with lacquer and with a connected drying station (4) in which the lacquer is dried and the solvent contained in the lacquer is evaporated and carried off, **characterised in that** the drying station (4) features a continuous flow drier (7) in accordance with any one of the preceding claims.

25. Coating plant (1) according to claim 24, **characterised in that** an abatement zone (BZ) is interposed between the coating unit (3) and the drying station (4), in which the lacquer is slackened and homogenised.

26. Coating plant (1) according to claim 25, **characterised in that** the drying station (4) has a downstream exposure and etching unit.

27. Method of drying coated boards (2) or webs, particularly coated inner plies or printed circuit boards, **characterised by** the following procedural steps:
- guiding the board (2) or web in the direction of transfer, along a conveyor belt (B) through a drying chamber (11),
- heating a stream of air (14), comprising several partial air currents (46), and forcibly directing it against the direction of transfer,
- blowing the board (2) or web, or conveyor belt (B) respectively, with substantially parallel partial air streams that cross the direction of transfer (8) at an angle (α) of 90° to 15°, and preferably 60° to 45°, against
the direction of transfer of the board (2) or web, and
- drying of the coating by blowing the board (2) or web with the partial streams of hot air (46), whereby the partial air streams (46) blown on to and flowing away from the board (2) or web are in each case sucked off and blown to another point on the conveyor belt (B) against the direction of transfer (B) in such a manner that a wavelike air motion is attained in the drying chamber (11).

28. Method according to claim 27, **characterised in that** the partial air streams (46) are blown on to the conveyor belt, or the board (2) or web, respectively, in a laterally reversed manner with respect to the conveyor belt (B), over its entire width, from above or beneath the conveyor belt (B).

29. Method according to one of the claims 27 to 28, **characterised in that** the partial streams of hot air (46) blowing on the board (2) or belt blow across the entire width of the board (2) or the belt.

30. Method according to one of the claims 27 to 28, **characterised in that** heating of the stream of air (27, 28) and/or of the partial air currents (46) is effected by heating elements, in particular electric heating elements (42).

31. Method according to any one of claims 27 to 30, **characterised in that** drying is effected in various heating zones (PH1, PH2, PH3, ZH1 and ZH2).

32. Method according to any one of claims 27 to 30, **characterised in that** the board (2) or web is swiftly and intensively heated in a first process heating zone and a supply air heating zone (PH1, ZH1).

33. Method according to one of claims 27 to 32, **characterised in that** fast and intensive heating is effected by blowing hot partial air streams (46) on to the board (2) or web and/or thermal radiation, particularly infrared radiation.

34. Method according to one of claims 27 to 33, **characterised in that** in the additional heating zones (PH2, PH3, ZH2), the board (2) or web is held at substantially the temperature to which it is heated in the first process heating zone and supply air heating zone (PH1, ZH1), and drying of the coating is effected by hot partial air streams (46) blown on to the board (2) or web.

35. Method according to one of claims 27 to 34, **characterised in that** the board (2) or web is cooled in a cooling zone (KI) downstream of one of the heating zones (PH1, PH2, PH3, ZH1, ZH2).

36. Method according to one of claims 27 to 35, **characterised in that** the air that is provided for cooling is blown in a substantially perpendicular manner on to the conveyor belt (B), or board, or web, respectively,

37. Method according to one of claims 27 to 36, **characterised in that** clean air is used for drying.

## Revendications

1. Sécheur en continu (7) de plaques (2) ou de bandes enduites, notamment pour cartes de circuits imprimés ou couches internes, avec une chambre de séchage (11) pourvue de moyens de transport (51) transportant la plaque (2) ou la bande le long d'une bande de transport (B) dans le sens de transport (8) via la chambre de séchage (11) d'une entrée de la chambre (13) à une sortie de la chambre (13), avec un courant d'air guidé de manière forcée dans la chambre de séchage (11) en sens inverse du sens de transport (8), avec une entrée (16, 35) et une sortie (32) du courant d'air, avec des unités de soufflage (36) pour produire le courant d'air et avec des éléments de chauffage pour chauffer le courant d'air, **caractérisé en ce que** les unités de soufflage (36) sont agencées au-dessus et / ou au-dessous le long de la bande de transport (B) parallèlement à la bande de transport (B), que les unités de soufflage (36) présentent respectivement une fente (44) située transversalement au sens de transport (8), de préférence sous un angle de 90°, et que des courants d'air partiels (46) du courant d'air sont soufflés au travers de la fente (44) sous un angle de souffle (α) de 90° à 15°, de préférence 60° à 45°, par rapport à la bande de transport (B) en sens inverse du sens de transport (8) sur la plaque (2) ou la bande et / ou sur la bande de transport (B), et que s'agissant de deux unités de soufflage (36) disposées de manière adjacente le long de la bande de transport (B), l'unité de soufflage (36) la plus proche de l'entrée de la chambre (12) aspire en partie au moins le courant d'air partiel (40, 36) soufflé de l'unité de soufflage (36) éloignée de l'entrée de la chambre (12) sur la plaque (2) ou la bande et s'écoulant au niveau de la plaque (2) ou de la bande et l'insuffle sur la plaque (2) ou la bande et / ou la bande de transport (B) à un autre endroit.

2. Sécheur en continu (7) selon la revendication 1, **caractérisé en ce que** les unités de soufflage (36) sont agencées de manière réfléchie par rapport à la bande de transport (B) au-dessus et au-dessous de la bande de transport (B).

3. Sécheur en continu (7) selon l'une des revendications 1 à 2, **caractérisé en ce que** plusieurs courants d'air partiels (46) agencés parallèlement l'un à l'autre, l'un derrière l'autre, sont soufflés sur la plaque (2) ou la bande sous l'angle de souffle (α) de 90° à 15°, de préférence 60° à 45°.

4. Sécheur en continu (7) selon l'une quelconque des revendications précédentes, **caractérisé en ce que** la fente (44) s'étend essentiellement parallèlement à la bande de transport (B) et recouvre complètement la largeur de la bande de transport (B) dans l'étendue longitudinale.

5. Sécheur en continu (7) selon l'une quelconque des revendications précédentes, **caractérisé en ce que** sur la face, tournée vers l'unité de soufflage (36) respective, de la fente (44) se trouvent des redresseurs d'air, qui provoquent une répartition uniforme de la température et de la vitesse, ainsi qu'une accélération du courant d'air partiel respectif (46).

6. Sécheur en continu (7) selon l'une quelconque des revendications précédentes, **caractérisé en ce que** les unités de soufflage (36) présentent des ventilateurs (41) pouvant pivoter autour d'un axe de rotation (38) et que l'axe de rotation (38) s'étend perpendiculairement à la bande de transport (B).

7. Sécheur en continu (7) selon la revendication 6, **caractérisé en ce que** les ventilateurs (41) aspirent de l'air provenant de la chambre de séchage (11) (7) dans la zone de l'axe de rotation (38).

8. Sécheur en continu (7) selon la revendication 6 ou 7, **caractérisé en ce que** les ventilateurs (41) sont agencés dans des boîtiers de ventilateurs (42) qui présentent une fente (44) selon la revendication 1.

9. Sécheur en continu (7) selon la revendication 8, **caractérisé en ce que** les boîtiers de ventilateurs (42) présentent, au niveau de leur face tournée vers la bande de transport (B) dans la zone de l'axe de rotation (38), une entrée d'air (47) pour l'admission de l'air à aspirer.

10. Sécheur en continu (7) selon la revendication 9, **caractérisé en ce que** l'entrée d'air (47) est une grille métallique (57).

11. Sécheur en continu (7) selon l'une des revendications 6 à 10, **caractérisé en ce que** les boîtiers de ventilateurs (42) présentent la fente (44) dans la zone tournée vers l'entrée de la chambre (12).

12. Sécheur en continu (7) selon l'une des revendications 6 à 11, **caractérisé en ce que** les éléments de chauffage sont agencés au niveau des boîtiers de ventilateurs (42) et / ou à l'intérieur de ces derniers.

13. Sécheur en continu (7) selon l'une quelconque des revendications précédentes, **caractérisé en ce que** les éléments de chauffage sont des éléments de chauffage électrique (43) et / ou des radiateurs aux rayons infrarouges.

14. Sécheur en continu (7) selon l'une des revendications 6 à 13, **caractérisé en ce que** les éléments de chauffage électrique (43) sont agencés à l'intérieur des boîtiers de ventilateurs (42) le long de la fente (44) au-dessus de la fente (44).

15. Sécheur en continu (7) selon la revendication 14, **caractérisé en ce que** les éléments de chauffage électrique (43) sont des éléments de chauffage à ailettes, dont les ailettes sont conçues comme des redresseurs d'air selon la revendication 5.

16. Sécheur en continu (7) selon l'une quelconque des revendications précédentes, **caractérisé en ce que** la chambre de séchage (11) présente plusieurs zones de chauffage, notamment deux zones de chauffage d'air amené (ZH1, ZH2) ainsi que trois zones de chauffage de traitement (PH1, PH2, PH3).

17. Sécheur en continu (7) selon la revendication 16, **caractérisé en ce que** la première zone de chauffage de traitement et d'air amené (PH1, ZH1) chauffe la plaque (2) ou la bande et que les autres zones de chauffage (PH2, PH3, ZH2) maintiennent la plaque (2) ou la bande essentiellement à la température chauffée dans la première zone de chauffage de traitement et d'air amené (PH1, ZH1).

18. Sécheur en continu (7) selon la revendication 16 ou 17, **caractérisé en ce que** les zones de chauffage de traitement (PH1, PH2, PH3) présentent un groupe d'unités de soufflage (36) avec ou sans éléments de chauffage.

19. Sécheur en continu (7) selon l'une des revendications 16 à 18, **caractérisé en ce que** les deux premières zones de chauffage de traitement (PH1, PH2) présentent des éléments de chauffage et que les autres zones de chauffage de traitement (PH3) ne présentent aucun élément de chauffage.

20. Sécheur en continu (6) selon l'une des revendications 16 à 19, **caractérisé en ce que**, avant les zones de chauffage de traitement (PH1, PH2, PH3), se trouvent des zones de chauffage d'air amené (ZH1, ZH2), qui réchauffent l'air amené aux zones de chauffage de traitement (PH1, PH2, PH3).

21. Sécheur en continu (7) selon les revendications 16 à 20, **caractérisé en ce qu'**une zone de refroidissement (KI) est intercalée à la suite des zones de chauffage (PH1, PH2, PH3, ZH1, ZH2).

22. Sécheur en continu (7) selon la revendication 21, **caractérisé en ce que**, dans la zone de refroidissement (KI), l'air est soufflé essentiellement perpendiculairement sur la plaque (2) ou la bande et / ou la bande de transport (B).

23. Sécheur en continu (7) selon l'une quelconque des revendications précédentes, **caractérisé en ce qu'**un filtre à air pur est prévu au niveau de l'entrée (16) du courant d'air (17) au niveau du sécheur en continu (7).

24. Dispositif d'enduction (1) pour l'enduction de plaques (2) ou de bandes, notamment de cartes de circuits imprimés ou de couches internes, pourvu d'une station d'enduction (3), dans laquelle la plaque (2) ou la bande est enduite de vernis d'un ou des deux côtés et d'une station de séchage (4) s'y rattachant, dans laquelle le vernis est séché et le solvant contenu dans le vernis est évaporé et éliminé, **caractérisé en ce que** la station de séchage (4) présente un sécheur en continu (7) selon l'une quelconque des revendications précédentes.

25. Dispositif d'enduction (1) selon la revendication 24, **caractérisé en ce que** entre la station d'enduction (3) et la station de séchage (4) se trouve une zone de calmage (βZ) dans laquelle le vernis se détend et s'homogénéise.

26. Dispositif d'enduction (1) selon la revendication 25, **caractérisé en ce qu'**une station d'exposition à la lumière et de décapage est intercalée à la suite de la station de séchage (4).

27. Procédé de séchage de plaques (2) ou bandes enduites, notamment de couches internes ou cartes de circuits imprimés enduites, **caractérisé par** les étapes de procédé suivantes :
- le guidage de la plaque (2) ou la bande le long d'une bande de transport (B) dans le sens de transport (8) à travers une chambre de séchage (11),
- le chauffage et le guidage forcé, en sens inverse du sens de transport (8), d'un courant d'air (14) présentant plusieurs courants d'air partiels (46) dans la chambre de séchage (11),
- le soufflage sur la plaque (2) ou la bande de courants d'air partiels (46) essentiellement parallèles, s'étendant transversalement au sens de transport (8), sous un angle de souffle (α) de 90° à 15°, de préférence 60° à 45°, par rapport à la bande de transport (B) en sens inverse du sens de transport (8) de la plaque (2) ou la bande et
- le séchage de l'enduction en raison du soufflage de la plaque (2) ou la bande à l'aide des courants d'air partiels (46), les courants d'air partiels (46) soufflés sur la plaque (2) ou la bande et s'écoulant au niveau de la plaque (2) ou la bande étant respectivement aspirés et insufflés à un autre endroit respectif, en sens inverse du sens de transport (8), sur la bande de transport (B) et / ou sur la plaque (2) ou la bande de telle manière qu'un souffle ondulatoire est obtenu à l'intérieur de la chambre de séchage (11).

28. Procédé selon la revendication 27, **caractérisé en ce que** les courants d'air partiels (46) soufflent sur la bande de transport (B) et / ou la plaque (2) ou la bande de manière réfléchie par rapport à la bande de transport (B) d'au-dessus et d'au-dessous de la bande de transport (B).

29. Procédé selon l'une des revendications 27 à 28, **caractérisé en ce que** les courants d'air partiels (46) soufflant sur la plaque (2) ou la bande soufflent sur la plaque (2) ou la bande sur toute sa largeur.

30. Procédé selon l'une des revendications 27 à 28, **caractérisé en ce que** le chauffage du courant d'air (27, 28) et / ou des courants d'air partiels (46) s'effectue par l'intermédiaire d'éléments de chauffage, notamment des éléments de chauffage électrique (42).

31. Procédé selon l'une des revendications 27 à 30, **caractérisé en ce que** le séchage s'effectue dans différentes zones de chauffage (PH1, PH2, PH3, ZH1, ZH2).

32. Procédé selon l'une des revendications 27 à 30, **caractérisé en ce que** la plaque (2) ou la bande est réchauffée de manière rapide et intensive dans une première zone de chauffage de traitement et zone de chauffage d'air amené (PH1, ZH1).

33. Procédé selon l'une des revendications 27 à 32, **caractérisé en ce que** le réchauffage rapide et intensif s'effectue au moyen des courants d'air partiels (46) chauds soufflés sur la plaque (2) ou la bande et / ou au moyen d'un rayonnement thermique, notamment un rayonnement infrarouge.

34. Procédé selon l'une des revendications 27 à 33, **caractérisé en ce que** dans les autres zones de chauffage (PH2, PH3, ZH2), la plaque (2) ou la bande est essentiellement maintenue à la température chauffée dans la première zone de chauffage de traitement et zone de chauffage d'air amené (PH1, ZH1) et que le séchage de l'enduction s'effectue par le biais des courants d'air partiels (46) chauds soufflés sur la plaque (2) ou la bande.

35. Procédé selon l'une des revendications 27 à 34, **caractérisé en ce que** la plaque (2) ou la bande est refroidie dans une zone de refroidissement (KI) intercalée après les zones de chauffage (PH1, PH2, PH3, ZH1, ZH2).

36. Procédé selon l'une des revendications 27 à 35, **caractérisé en ce que** l'air prévu pour le refroidissement est soufflé essentiellement perpendiculairement sur la bande de transport (B) et / ou la plaque (2) ou la bande.

37. Procédé selon l'une des revendications 27 à 36, **caractérisé en ce que** le séchage s'effectue en utilisant de l'air pur.
